# EUROPEAN PATENT APPLICATION

(11) **EP 4 826 995 A1**
(43) Date of publication of application: **21.10.2026**
(21) Application number: 25170668.5
(22) Date of filing: 15.04.2025
(51) Int. Cl.: H03F 1/02, H03F 3/187, H03F 3/217

(54) **A SWITCHING AMPLIFIER AND A METHOD FOR ADJUSTING A SWITCHING FREQUENCY AND AN ACTIVE SPEAKER**

(71) Applicant: Pascal A/S, 2730 Herlev (DK)
(72) Inventor: Hansen, Jesper Lind, 2730 Herlev (DK); Iversen, Niels Elkjær, 2730 Herlev (DK)
(74) Representative: Patrade A/S

(57) **Abstract**

The present invention relates to a switching amplifier (1) for generating an amplified output signal (42) and a method for adjusting a switching frequency (62) of a switching amplifier (1). The switching amplifier (1) comprises: a modulator (20) configured for generating a pulse signal (22) with a switching frequency (62), wherein the pulse signal (22) is based on a first control signal (12); a power stage (40) comprising at least two transistors, wherein the power stage is configured for generating an amplified output signal (42) based on the pulse signal (22); and a frequency controller (60) configured for adjusting the switching frequency (62) of the modulator (20), wherein the switching frequency is increased at low amplified output signal (42) and the switching frequency is reduced at high amplified output signal.

## Description

### Field of the Invention

The present invention relates to a switching amplifier for generating an amplified output signal and a method for adjusting a switching frequency of a switching amplifier. The invention also relates to an active speaker comprising one or more switching amplifiers and a computer program and computer-readable medium for causing the switching amplifier to execute the method.

### Background of the Invention

In theory a switching amplifier or class-D amplifier is fully efficient, i.e., 100% efficient, because it is assumed to be an ideal switch, and hence delivers all the supplied power to a load with none of the power being converted to heat. This is due to an ideal switch having zero resistance and thus there is zero voltage drop across the ideal switch when it is "turned on". Furthermore, the ideal switch does not dissipate any power while "turned off", which may be due to leakage current flowing through the switch.

However, in real world applications the switching amplifier generally has an efficiency of around 90% or above. Thus, a challenge in the field of switching amplifiers is to improve the efficiency even further by reducing losses in the switching amplifier. Solving this challenge provides advantages such as less power consumption per switching amplifier, which in turn means that a larger total power output is achievable and/or the power consumption is reduced which impacts greenhouse gas emissions. A further advantage is that when less power is dissipated as heat the electric components can achieve a longer lifespan. Furthermore, an improved efficiency may allow the switching amplifier to be constructed using cheaper components while achieving comparable performance in terms of power efficiency and/or audio performance.

The losses in the switching amplifier may occur in the power stage and/or in an output filter connected to the power stage.

Switching losses occurs during switching of the power transistors when current ramps up and down together with the drain-source voltage and when the parasitic output capacitance of the power transistors cannot be charged and/or discharged in the dead-time between the turn on and turn off of the power transistors. The latter aspect may be referred to as a hard switching event. However, when the parasitic output capacitance is partially or fully charged and/or discharged in the dead-time, zero voltage switching (ZVS) and/or reduced voltage switching (RVS) is achieved which improves efficiency. This solution to hard switching is a so-called soft switching, which reduces the power dissipation when the voltage is near zero when the power transistors turn on and the current starts flowing.

Furthermore, gate losses occur when the gate capacitance of the power transistors are charged and discharged during switching; conduction losses occur when current flows in the transistor due to the drain-source resistance of the transistors; and body diode losses occurs when the output current continues to flow in the body diode of the transistor after being switched off, which in turn needs to be reversed in the next switching event, causing a reverse recovery loss.

An output filter may typically include a capacitor, and an inductor connected between the switching amplifier and a load, the output filter is configured as a low pass filter. The losses in the output filter are typically magnetic core losses and conduction losses.

Conduction losses may comprise high frequency losses and low frequency losses. The high frequency losses may depend on a ripple current of the inductor and an alternating current (AC) resistance. The low frequency losses may depend on an output current of the output filter and the direct current (DC) resistance.

Magnetic core loses may depend on the magnetic flux density, shape and material of the inductor.

### Object of the Invention

One objective of the present disclosure is to achieve a switching amplifier with increased efficiency. The efficiency may be achieved by reducing combined amplifier switching losses and magnetic core losses.

A further objective is to provide a method for adjusting a switching frequency in a switching amplifier.

### Description of the Invention

One objective of the invention is achieved by a switching amplifier for generating an amplified output signal, wherein the switching amplifier comprises:
- a modulator configured for generating a pulse signal with a switching frequency, wherein the pulse signal is based on a first control signal;
- a power stage comprising at least two transistors, wherein the power stage is configured for generating an amplified output signal based on the pulse signal; and
- a frequency controller configured for adjusting the switching frequency of the modulator, wherein the switching frequency is increased at low amplified output signal and the switching frequency is reduced at high amplified output signal.

In one aspect, the frequency controller may be a controlled external carrier generator, configured to generate a carrier waveform which is transmitted to an input of the modulator. The carrier waveform has the switching frequency, so that when the frequency controller adjusts the switching frequency, the frequency of the pulse signal generated by the modulator is adjusted accordingly. In another aspect, the modulator may be a self-generated carrier modulator such as a self-oscillating modulator, the typical options are a hysteresis modulator or a phase-shift modulator, configured to receive a signal from the frequency controller which adjusts the switching frequency of the hysteresis modulator or phase-shift modulator.

The frequency controller may be configured to adjust the switching frequency only when it is advantageous to do so, i.e., in terms of improved power efficiency and/or audio performance. The improved efficiency may be obtained when ZVS and/or RVS is achieved. Although ZVS and RVS improves the efficiency of the switching amplifier, it may not be feasible and/or efficient to obtain ZVS and/or RVS throughout the entire time when the switching amplifier is operating. This may be referred to as an active frequency control (AFC) principle. One example may be a case where an output power of the switching amplifier is very high and the switching frequency is also very high, leading to very high losses. The frequency controller may be configured to lower the switching frequency at high amplified output signal, high output power, high output current, etc., thus reducing the very high losses.

In one aspect, a low amplified output signal may be a signal close to an idle state. Idle state may also be referred to as a steady state or a state where only quiescent current flows. A high amplified output signal may be a signal being in a range just above idle state and up to a maximum capacity of the power stage. The adjustment of the switching frequency may be made relative to the increase and the decrease of the amplified output signal, as the amplified output signal is related to an output power and/or output current of the switching amplifier. The output power is the electrical power of an output signal transferred from the switching amplifier to an output load such as a speaker driver.

In one aspect, the switching frequency may be increased at low currents of the amplified output signal and the switching frequency may be reduced at high currents of the amplified output signal. In a further aspect, the low and high currents may be the current of the output signal in an output load.

The optimal switching frequency for improved power efficiency may be dependent on the output load, as a lower load resistance results in a higher output current, and hence a lower switching frequency is required to obtain zero voltage switching and/or reduced voltage switching.

One advantage of increasing the switching frequency at low output currents is to reduce magnetic core losses while ensuring that the transistors in the power stage are still soft switched. i.e., the opposite of hard switching. Thus, at around 0 volts (V) output voltage, i.e. idle state, the aforementioned magnetic core losses are reduced.

In one aspect, the first control signal may be generated based on an input signal. The input signal may be a signal generated by a signal generator such as a sine wave or similar or the input signal may be an audio input or similar generated by a digital-to-analogue converter or an analogue media player such as a tape, record player, radio, etc.

In a further aspect, the first control signal may be substantially an exact representation of the input signal, or it may be generated based on the input signal in an input stage. The input stage may comprise an audio controller configured to generating the first control signal. Furthermore, the audio controller may be implemented with feedback, e.g., the audio controller may receive a first feedback signal, wherein the first feedback signal may be based on the output signal of the switching amplifier, as e.g. a voltage or current measurement of the output signal.

In a further aspect, the switching amplifier may comprise a power supply having a neutral ground, a positive power supply, and/or a negative power supply. The advantageous effects of the disclosed AFC principle are particularly more advantageous for power supplies having a voltage supply above 100 V and especially in the range of 150 to 200 V or even more preferably 170 to 180 V, the voltage supply may be a single voltage supply or a positive and negative power supply, e.g., ±180 V.

In a further aspect, the pulse signal may be a pulse-width modulation (PWM) signal, pulse density signal, sigma-delta modulation signal, spread-spectrum modulation signal, etc. The carrier waveform may be a triangle signal.

In a further aspect, the switching amplifier comprises a gate driver configured to generate a drive current to the transistors of the power stage, wherein the drive current is based on the pulse signal.

In a further embodiment of the switching amplifier, the frequency controller is configured for adjusting the switching frequency based on one or more second control signals measured directly and/or indirectly, wherein the one or more second control signals are configured to determine an output current, wherein the one or more second control signals are chosen among:
- the first control signal; and/or
- a voltage of the amplified output signal; and/or
- a current of the amplified output signal; and/or
- a current draw of a power supply powering the power stage; and/or
- a voltage of the power supply powering the power stage.

Instead of determining the output current, an output power may be determined instead and may be used for adjusting the switching frequency according to AFC. Using output power is possible due to the empirical relation as defined in Ohm's law and Joule's first law. The same principle may be applicable to other measured and/or determined currents.

The output current is a current supplied to an output load, e.g., a speaker.

Generally, any signal capable of being utilized to determine the output current of the switching amplifier may be used for adjusting the switching frequency. I.e., the above list of signals is non-exhaustive.

The first control signal may also be the input signal or may be based on the input signal, hence the second control signal may also be a direct or indirect measurement of the input signal. The first control signal and/or the input signal may be used to determine the output current by knowing a gain magnitude of the switching amplifier and/or the resistance of the output load and utilizing Ohm's law. This is an advantage of an active speaker wherein the one or more output loads is a known constant.

The optimal switching frequency may be dependent on the output load. However, one advantage of the present invention is that the AFC can be a load independent implementation, by measuring directly and/or indirectly both the voltage and current of the amplified output signal and/or the output signal, and the frequency controller can thus adjust the switching frequency to be the optimal switching frequency of the specific load.

The AFC may also function as a load dependent implementation, wherein the AFC of the frequency controller minimizes the losses in the idle state by increasing the switching frequency.

The adjustment of the switching frequency made by the frequency controller may also be based on a current draw and/or voltage of the one or more power supplies powering the power stage, as the current draw may be a direct result of the amplification of the power stage and thus a representation of the output power of the switching amplifier. Hence, the current draw and/or voltage may be used to determine the output power. The current draw of the one or more power supplies may also be the current in the one or more transistors in the power stage.

By determining the output current and/or any second control signals configured to determine the output current such as the current of the amplified output signal, the output current, the current draw of the power supply, the current in the one or more transistors, etc. the losses of the amplifier may be reduced, by utilizing the frequency controller and the active frequency control principle.

In a further embodiment of the switching amplifier, the switching amplifier comprises an output stage configured for generating an output signal, wherein the output stage comprises a capacitor and an inductor having an inductor ripple current.

The output stage may be configured to filter out high frequency components in the amplified pulse signal so that the output signal is an amplification of the input signal or the first control signal. I.e., the output stage may be a low pass filter.

The output stage may be configured to be connected to an output load, such as a speaker driver. In another aspect, the output stage may be incorporated or integrated in a speaker cabinet comprising a speaker driver, so that the switching amplifier is a so-called filter-less amplifier. In another aspect, the speaker and switching amplifier may be a filter-less configuration, wherein the output of the switching amplifier is transmitted to the speaker driver directly. In this aspect, the switching amplifier utilizes that the speaker driver is inductive. Hence, the speaker driver may have an inductor ripple current, and the AFC may be utilized to optimize the efficiency of the switching amplifier and speaker combination.

In a further aspect of the switching amplifier, the frequency controller may be configured for adjusting the switching frequency so that a magnitude of the inductor ripple current of the inductor is larger than a current magnitude of the output signal, the output current at the output load and/or a signal determining the output signal.

According to the general Steinmetz equation, increasing the frequency at idle will reduce the magnetic core losses as long as the magnetic flux component cancels out the frequency component. Ensuring this cancelling may be achieved because the magnetic flux component is inversely proportional to the switching frequency, hence the magnetic core losses may be reduced by implementing AFC and selecting one or more inductors with the correct core materials.

In one aspect, the current magnitude of the output signal may be determined based on any one or more of the second control signals, in particular the amplified output signal of the power stage.

The switching frequency may be adjusted by the frequency controller so that the losses in the inductor are as small as possible. This may advantageously be done during low output signal i.e., during idle state, by increasing the frequency.

Maintaining an inductor ripple current that is larger than the current magnitude of the output signal, the output current at the output load and/or the signal determining the output signal is advantageous as it enables the transistors of the power stage to operate in ZVS and/or RVS, hence improving efficiency. This is due to the drain-source voltage of the transistors being charged and discharged in part by the inductor ripple current.

As described, the AFC may be configured to be enabled when it is advantageous in terms of reducing the losses, the same applies to increasing the switching frequency so that the inductor ripple current is larger than the current magnitude of the output signal, the output current at the output load and/or the signal determining the output signal. The frequency controller may not necessarily be configured to adjust the switching frequency as disclosed above across the entire input range and/or amplification range of the switching amplifier.

In one aspect of the switching amplifier, the frequency controller may be configured for adjusting the switching frequency so that a magnitude of the inductor ripple current is in the range of 1 to 10 Amperes (A), 2 to 8 Amperes, 4 to 6 Amperes or 3 Amperes or another range of 1 to 50 A, 10 to 40 A or 20 to 30 A. The specific ranges may be adequate for normal operation of the switching amplifier, e.g., where the switching amplifier outputs approximately 1/8 of the maximum output power on average. However, the inductor ripple current may require to momentarily be above the specific range for very high output power, in order to obtain an efficient amplification by achieving ZVS.

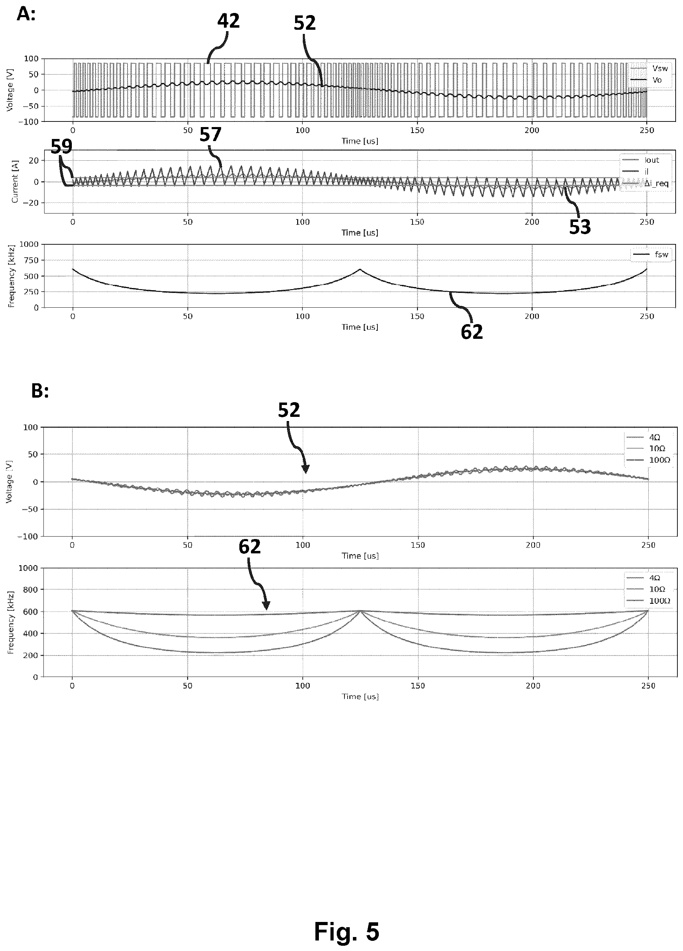

In one example, the switching amplifier may comprise a power supply having an approximate of 170 V rail-to-rail supply voltage and the inductor having an inductance of 10 micro henry (uH). The optimal switching frequency to obtain ZVS with a specific inductor ripple current for various loads and output voltage are illustrated in figure 5A.

In one aspect of the switching amplifier, the frequency controller may be configured to limit the switching frequency at a minimum frequency so that a maximum magnitude of the inductor ripple current is limited.

An advantageous effect is achieved as a minimum switching frequency may improve audio performance, as the high frequency components of the pulse signal and/or the amplified output signal are sufficiently filtered by the low pass filter effect of the output stage. E.g., the cut-off frequency of the low pass filter may be in the range of 40 to 80 kilo Hertz (kHz), wherein by limiting the minimum switching frequency to 100 kHz, the high frequency components in the pulse signal are filtered sufficiently so that audio performance is greatly improved.

In a further embodiment of the switching amplifier, the frequency controller is configured for adjusting the switching frequency based on one or more second control signals measured directly and/or indirectly, wherein the one or more second control signals are configured to determine an output current, wherein the one or more second control signals are chosen among:
- a voltage of the output signal; and/or
- a current of the output signal; and/or
- a current of the inductor; and/or
- a current of the capacitor.

As described previously, the output power may be determined instead of the output current.

The current of the inductor and/or the current of the capacitor refer to the inductor and capacitor being a part of the output stage, i.e., an output filter.

In a further embodiment of the switching amplifier, the frequency controller is configured to hold the switching frequency constant momentarily after a reduction in switching frequency and before the switching frequency is increased.

Holding the switching frequency constant momentarily is advantageous when the first control signal or the input signal comprises bursts, as during a sound burst the fast-varying switching frequency may introduce undesired non-linearities into the amplified output signal. While the efficiency may not be as good during operation in this type of implementation compared to an AFC controller with no hold time, the losses are still reduced in idle and between larger bursts. Since music is dynamic, the hold implementation will still benefit the overall efficiency of the amplifier, reduce losses, and improve sound performance.

In a further aspect of the switching amplifier, the frequency controller may be configured to disable adjustment of the switching frequency momentarily so that the switching frequency is at a constant frequency.

Disabling the adjustment of the switching frequency by the frequency controller may be advantageous to e.g. improve audio performance in certain cases or advantageous for cases where the efficiency improvement of the adjustment is negligible.

In a further embodiment of the switching amplifier, the frequency controller is an external carrier generator configured to generate a carrier waveform having the switching frequency and configured to transmit the carrier waveform to the modulator, wherein the modulator generates the pulse signal based on the first control signal and the carrier waveform.

The carrier waveform has the switching frequency, so that when the frequency controller adjusts the switching frequency, the frequency of the pulse signal generated by the modulator is adjusted accordingly. The carrier waveform may be any one of the different pulse signals described herein. In one aspect, the modulator may be a comparator.

In a further embodiment of the switching amplifier, the modulator is a self-oscillating hysteresis modulator receiving:
- a feedback signal based on the amplified output signal; and/or
- a hysteresis control signal generated by the frequency controller and based on the one or more second control signals, wherein the hysteresis control signal is a pulse signal having decreasing frequency for high amplified output signal and increasing frequency for low amplified output signal,
wherein the hysteresis control signal is actively clamped between the feedback signal and the pulse signal generated by the self-oscillating hysteresis modulator.

The self-oscillating hysteresis modulator may be configured to generate the pulse signal with the switching frequency based on the feedback signal, the first control signal and/or the hysteresis control signal. The hysteresis of the self-oscillating hysteresis modulator is thereby said to be controlled by the frequency controller.

The clamping of the hysteresis control signal to the self-oscillating hysteresis modulator is advantageous as it implements AFC in a similar manner to a modulator receiving a carrier waveform with active frequency control. Hence the same benefits to power efficiency and audio performance are achieved.

In one aspect, the frequency controller may comprise:
- a sensing circuit configured for generating a sensed signal based on the one or more second control signals;
- a rectifier circuit configured for generating a rectified signal based on the sensed signal;
- a clamping inverter configured for generating a clamped signal, wherein the clamped signal is low for low magnitudes of the one or more second control signals and the clamped signal is high for high magnitudes of the one or more second control signals; and
- a hysteresis clamp configured for generating the hysteresis control signal comprising a positive-shifted clamper signal and a negative-shifted clamper signal based on the clamped signal.

In one aspect, a current of the inductor may be sensed using a hall-effect sensor or a current of the output signal may be sensed using a shunt resistor placed in series with the inductor and the load.

In another aspect, the rectifier circuit may also amplify the sensed signal, e.g. by using an operational amplifier.

In another aspect, the second feedback signal may be combined with the first feedback signal at the input of the self-oscillating modulator.

In a further embodiment of the switching amplifier, the modulator is a self-oscillating phase-shift modulator comprising a control-loop configured to generate oscillation with the switching frequency and wherein the frequency controller is configured to adjust the switching frequency of the oscillation by introducing a delay to the control-loop.

The oscillation may be used to generate the pulse signal of the modulator.

The delay introduced to the control-loop may be controlled according to the AFC principle, so that the switching frequency of the pulse signal is adjusted in order to optimize the efficiency of the switching amplifier.

In one aspect, the control-loop may comprise a feedback-loop comprising a combination of gain-, pole- and zero-components configured to generate the oscillation. The oscillation may be generated in combination with one or more active components, such as an operational amplifier. The components may be provided by passive components such as resistors, capacitors and/or inductors. To adjust the delay of the feedback-loop and thus adjust the switching frequency, the frequency controller may be configured to adjust the time constant in the feedback-loop. The time constant may be adjusted by providing a controllable resistance, a controllable capacitor, a connection/disconnection of the capacitor to the feedback-loop and/or a combination thereof.

In a further aspect of the control-loop, the control-loop may comprise a forward path or a feed-forward loop. The control-loop may comprise a combination of the feedback-loop, the forward path and/or the feed-forward loop. The same aforementioned aspects of the feedback-loop are applicable to the forward path and/or the feed-forward loop.

In a further embodiment of the switching amplifier, the transistors of the power stage are chosen among bipolar junction transistors, field-effect transistors, junction field-effect transistors, metal-oxide-semiconductor field-effect transistors, gallium nitride field-effect transistors, silicon carbide field-effect transistors, and/or insulated-gate bipolar transistor.

Using gallium nitride field-effect transistors and/or silicon carbide field-effect transistors is advantageous as the operating frequency are generally higher than e.g. regular field-effect transistors and metal-oxide-semiconductor field-effect transistors, thus resulting in lower inductor losses at idle.

In principle the switching frequency can be increased infinitely to increase the efficiency of the switching amplifier of the present invention, since the inductor ripple current is inversely proportional to the switching frequency. However, current transistors suitable for switching amplifiers, and in particular high-power amplifiers for e.g., audio reproduction, have a maximum practical operating frequency due to parasitic effects limiting the maximum switching frequency. However, future developments in transistor technology may also be suitable for the present invention. The same applies to developments in inductors and core materials.

A further objective of the invention is achieved by an active speaker comprising one or more speaker drivers and one or more switching amplifier according to any one of the herein disclosed embodiments, wherein the switching amplifier is configured for powering the one or more speaker drivers.

One advantage of providing the active speaker with the switching amplifier, is that the load of the speaker drivers in the active speaker is known and therefore the AFC can be implemented to be as efficient as possible. This is advantageous in that the current does not need to be measured, as it can be easily determined with knowledge of the load of the speaker and one or more voltages of the switching amplifier.

The active speaker may be a point-source speaker such as a full-range speaker, a subwoofer, a speaker module for a line-source array or a matrix array.

In one aspect, the active speaker may comprise one or more cross-over filters. The switching amplifier and/or cross-over filters may comprise one or more amplifier outputs configured for powering one or more additional passive speaker enclosures. E.g., a full-range speaker or an active subwoofer may power an external subwoofer enclosure.

A further objective of the invention is achieved by a method for adjusting a switching frequency of a switching amplifier in order to reduce combined amplifier switching losses and magnetic core losses, wherein the method comprises the steps of:
- receiving a first control signal;
- generating a pulse signal with the switching frequency, wherein the pulse signal is based on the first control signal;
- amplifying the pulse signal to generate an amplified output signal having an output power; and
- adjusting the switching frequency by increasing the switching frequency at low amplified output signal and by reducing the switching frequency at high amplified output signal.

The herein disclosed method is configured to implement the AFC principle. Hence, the advantageous effects of the switching amplifier in regard to the AFC principle also applies to the one or more embodiments of the method for adjusting the switching frequency.

In one aspect, the method may comprise one or more further steps chosen among:
- generating a first control signal based on an input signal; and/or
- generating a gate current configured to drive transistors used to amplify the pulse signal, wherein the gate current is based on the pulse signal; and/or
- filtering the amplified pulse signal so that an output signal is generated; and/or
- generating the first feedback signal based on the amplified output signal.

The first feedback signal may be used in an audio controller, configured to generate the first control signal based on the input signal and/or the first feedback signal.

In a further embodiment of the method, in the step of adjusting the switching frequency, the switching frequency is based on one or more second control signal measured directly and/or indirectly, wherein the one or more second control signals are configured to determine an output current, wherein the one or more control signals are chosen among:
- the first control signal; and/or
- a voltage of the amplified output signal; and/or
- a current of the amplified output signal; and/or
- a current draw of a power supply used in the step of amplifying the pulse signal; and/or
- a voltage of the power supply used in the step of amplifying the pulse signal.

In a further aspect of the method, the method may comprise a further step of measuring the one or more second control signals.

The output power may be determined instead of the output current. The output power is the power transferred from the switching amplifier to a load, and thus also the measured power of the output signal.

The adjustment of the switching frequency may be done when one or more second control signals are substantially equal to an idle state or a steady state.

In a further embodiment of the method, the method comprises a further step of:
- filtering the amplified pulse signal so that an output signal is generated, wherein the filtering is achieved by a capacitor and an inductor having an inductor ripple current. In a further aspect of the method, the method may comprise a step of adjusting the switching frequency so that a magnitude of the inductor ripple current of the inductor is larger than a current of the output signal and/or a signal determining the output signal.

In a further embodiment of the method, in the step of adjusting the switching frequency, the switching frequency is based on one or more second control signals measured directly and/or indirectly, wherein the one or more second control signals are configured to determine an output current, wherein the one or more second control signals are chosen among:
- a voltage of the output signal; and/or
- a current of the output signal; and/or
- a current of the inductor; and/or
- a current of the capacitor.

The output power may be determined instead of the output current.

In a further embodiment of the method, the step of generating the pulse signal comprises further steps of:
- generating a second feedback signal based on the amplified output signal;
- generating a hysteresis control signal based on the second control signal, wherein the hysteresis control signal is a pulse signal having decreasing frequency for high amplified output signal and increasing frequency for low amplified output signal; and
- clamping the hysteresis control signal between the second feedback signal and the pulse signal.

In one aspect, the hysteresis control signal may be based on a signal determining an output signal of the switching amplifier, i.e., the signal transferred to a load.

In one aspect, in the step of generating the pulse signal, the pulse signal may be based on one or more signals chosen between:
- the first control signal;
- the first feedback signal;
- the second feedback signal; and/or
- an active clamping of the hysteresis control signal between the second feedback signal and the pulse signal.

In a further aspect of the step of generating the hysteresis control signal, the method comprises further steps of:
- sensing the output signal current to generate a sensed signal;
- rectifying the sensed signal to generate a rectified signal;
- generating a clamped signal based on the rectified signal, wherein the clamped signal is low for low magnitudes of the output signal current and the clamped signal is high for high magnitudes of the output signal current; and
- generating the hysteresis control signal comprising a positive-shifted clamper signal and a negative-shifted clamper signal based on the clamped signal.

A further objective of the invention is achieved by a use of the one or more embodiments of the method for adjusting the switching frequency of a switching amplifier, wherein the switching amplifier is according to any one or more of the herein disclosed embodiments.

A further objective of the invention is achieved by a computer program comprising instructions to cause the switching amplifier of any one of the herein disclosed embodiments to execute the steps of the method of any one of the herein disclosed embodiments.

A further objective of the invention is achieved by a computer-readable medium having stored thereon the computer program.

In one aspect, the computer-readable medium is a non-transitory computer readable medium, e.g., a flash memory, magnetic disks or tapes, optical discs, a non-volatile random-access memory, etc.

### Description of the Drawing

Various examples are described hereinafter with reference to the figures. Like reference numerals refer to like elements throughout. Like elements will, thus, not be described in detail with respect to the description of each figure. It should also be noted that the figures are only intended to facilitate the description of the examples. They are not intended as an exhaustive description of the claimed invention or as a limitation on the scope of the claimed invention. In addition, an illustrated example need not have all the aspects or advantages shown. An aspect or an advantage described in conjunction with a particular example is not necessarily limited to that example and can be practiced in any other examples even if not so illustrated, or if not so explicitly described.

Exemplary embodiments of the invention are described in the figures, whereon:
Fig. 1A illustrates one embodiment of a switching amplifier.
Fig. 1B illustrates one further embodiment of a switching amplifier.
Fig. 1C illustrates one further embodiment of a switching amplifier.
Fig. 2 illustrates one embodiment of an output stage and load.
Fig. 3A illustrates one embodiment of a switching amplifier with a self-oscillating hysteresis modulator.
Fig. 3B illustrates one further embodiment of a switching amplifier with a self-oscillating hysteresis modulator.
Fig. 4A illustrates one embodiment of a switching amplifier with a self-oscillating phase-shift modulator.
Fig. 4B illustrates one further embodiment of a switching amplifier with a self-oscillating phase-shift modulator.
Fig. 5A illustrates time domain graphs of electrical signals of a switching amplifier connected to a 4 Ohm load.
Fig. 5B illustrates time domain graphs of electrical signals of a switching amplifier connected to various loads.
Fig. 6A illustrates time domain graphs of electrical signals of a switching amplifier with a minimum switching frequency of 100 kHz.
Fig. 6B illustrates time domain graphs of electrical signals of a switching amplifier with a hold function.
Fig. 6C illustrates time domain graphs of electrical signals of a switching amplifier with a self-oscillating hysteresis modulator.
Fig. 7A-7C illustrate graphs of the efficiency/loss of three switching amplifiers relative to the output power.
Fig. 8A-8C illustrate switching characteristics of three switching amplifiers.
Fig. 9A-9C illustrate thermography images of circuit components of three switching amplifiers operating in steady state.
Fig. 10A-10E illustrate embodiments of a method for adjusting a switching frequency of a switching amplifier.

### Detailed Description of the Invention

Exemplary examples will now be described more fully hereinafter with reference to the accompanying drawings. In this regard, the present examples may have different forms and should not be construed as being limited to the descriptions set forth herein. Accordingly, the examples are merely described below, by referring to the figures, to explain aspects.

Throughout the specification, when an element is referred to as being "connected" to another element, the element is "directly connected" to the other element, "electrically connected", "fluidic connected", or "communicatively connected" to the other element with one or more intervening elements interposed there between.

The terminology used herein is for the purpose of describing particular examples only and is not intended to be limiting. As used herein, the terms "comprises", "comprising", "includes", and/or "including" when used in this specification specify the presence of stated features, integers, steps, operations, elements, and/or components, but do not preclude the presence or addition of one or more other features, integers, steps, operations, elements, components, and/or groups thereof.

Unless otherwise defined, all terms used herein (including technical and scientific terms) have the same meaning as commonly understood by those skilled in the art to which this invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined in the present specification.

| **Reference:** | **Reference number:** |
|---|---|
| Switching amplifier | 1 |
| Input stage | 10 |
| Hysteresis clamp | 100 |
| Hysteresis control signal | 102 |
| Positive-shifted clamper signal | 104 |
| Negative-shifted clamper signal | 106 |
| Input signal | 11 |
| First control signal | 12 |
| Modulator | 20 |
| Method | 200 |
| First feedback signal | 21 |
| Generating | 210 |
| Pulse signal | 22 |
| Generating | 220 |
| Self-oscillating hysteresis modulator | 23 |
| Second feedback signal | 24 |
| Amplifying | 240 |
| Self-oscillating Phase-shift modulator | 25 |
| Filtering | 250 |
| Generating | 255 |
| Generating | 256 |
| Control-loop | 26 |
| Adjusting | 260 |
| Adjusting | 262 |
| Delay block | 27 |
| Sensing | 270 |
| Controllable delay | 28 |
| Rectifying | 280 |
| Gain-, pole- and zero-components | 29 |
| Generating | 290 |
| Gate driver | 30 |
| Generating | 300 |
| Clamping | 310 |
| Drive current | 32 |
| Power stage | 40 |
| Amplified output signal | 42 |
| Power supply | 45 |
| Turn-on time | 46 |
| Drive circuit | 48 |
| Output load | 5 |
| Output stage | 50 |
| Output signal | 52 |
| Output current | 53 |
| Inductor | 56 |
| Inductor ripple current | 57 |
| Capacitor | 58 |
| Frequency controller | 60 |
| Control signal | 61a,61b,61c,61d |
| Switching frequency | 62 |
| Delay | 63 |
| Speaker drivers | 7 |
| Sensing circuit | 70 |
| Sensed signal | 72 |
| Efficiency | 8 |
| Rectifier circuit | 80 |
| Rectified signal | 82 |
| Loss | 9 |
| Clamping inverter | 90 |
| Clamped signal | 92 |

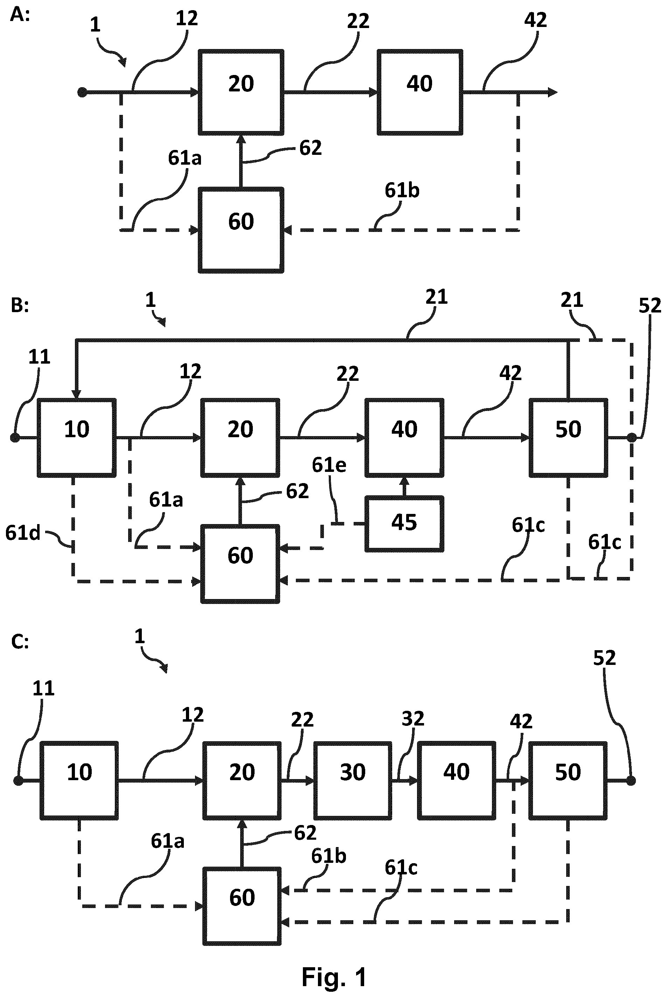

Figure 1A illustrates one embodiment of a switching amplifier 1 comprising a modulator 20, a power stage 40 and a frequency controller 60. The modulator 20 receives a first control signal 12 and is configured to generate a pulse signal 22 having a switching frequency 62 based on the first control signal 12. The power stage 40 receives the pulse signal 22 and is configured to generate an amplified output signal 42 based on the pulse signal 22 using at least two transistors. The amplified output signal 42 may be transmitted to an output load (not illustrated here) and the first control signal 12 may be received from an arbitrary input signal.

The frequency controller 60 is configured for adjusting the switching frequency 62 of the modulator 20. The switching frequency 62 is increased at low amplified output signal 42 and is decreased at high amplified output signals 42. The high and/or low amplified output signal 42 may be the absolute value of the signal, e.g., the power, current and/or voltage measurement of the signal.

The frequency controller 60 adjusts the switching frequency based on one or more second control signals 61a,61b determining an output power of the switching amplifier. The output power is the absolute value of the power transferred from the switching amplifier to a load. The one or more second control signals may be a direct and/or indirect measurement of the first control signal 12, or a voltage or current of the amplified output signal 42. The second control signal may be indirectly measured by knowledge of the gain magnitude of the switching amplifier and/or the resistance of the load.

Figure 1B illustrates one further embodiment of a switching amplifier 1 similar to the embodiment illustrated in Fig. 1A, wherein the switching amplifier comprises an input stage 10, an output stage 50, and a power supply 45.

The input stage 10 is configured to generate the first control signal 12 based on an input signal 11. The input stage 10 may comprise an audio controller configured to generate the first control signal 12. Furthermore, the input stage 10 receives a first feedback signal 21 from the output stage 50. The first feedback signal 21 may be based on an output signal 52 or it may be a signal coupled to the output load. The input signal 11 may also be used as a second control signal 61d transmitted to the frequency controller 60 to adjust the switching frequency 62.

The output stage 50 is configured to generate the output signal 52 based on the amplified output signal 42. The output stage 50 may comprise a low-pass filter comprising an inductor and a capacitor, wherein the low-pass filter is configured to attenuate high frequency signals. Hence, the output signal 52 is an amplification of the input signal 11.

The output stage 50 may transmit a second control signal 61c to the frequency controller 60, wherein the second control signal 61c may be used to adjust the switching frequency 62. The second control signal 61c may be used to determine the output power of the switching amplifier 1, wherein the signal may be a current of the inductor or the capacitor. The second control signal 61c may optionally be the voltage or current of the output signal 52. The second control signal 61c may be measured directly or indirectly as previously described herein.

The power supply 45 is configured to generate a supply voltage which is transmitted to at least two transistors in the power stage 40. The power supply 45 may also transmit a second control signal 61e to the frequency controller 60, wherein the second control signal 62e may be used to adjust the switching frequency 62. The second control signal 61e is a current draw of the power supply 45, the current draw may be used to determine the output power of the switching amplifier 1.

Figure 1C illustrates one further embodiment of the switching amplifier 1 as illustrated in fig. 1A and 1B. In this embodiment the switching amplifier 1 comprises a gate driver 30 configured to receive the pulse signal 22 and generate a drive current 32 based on the pulse signal 22. The drive current 32 is transmitted to the transistors of the power stage 40.

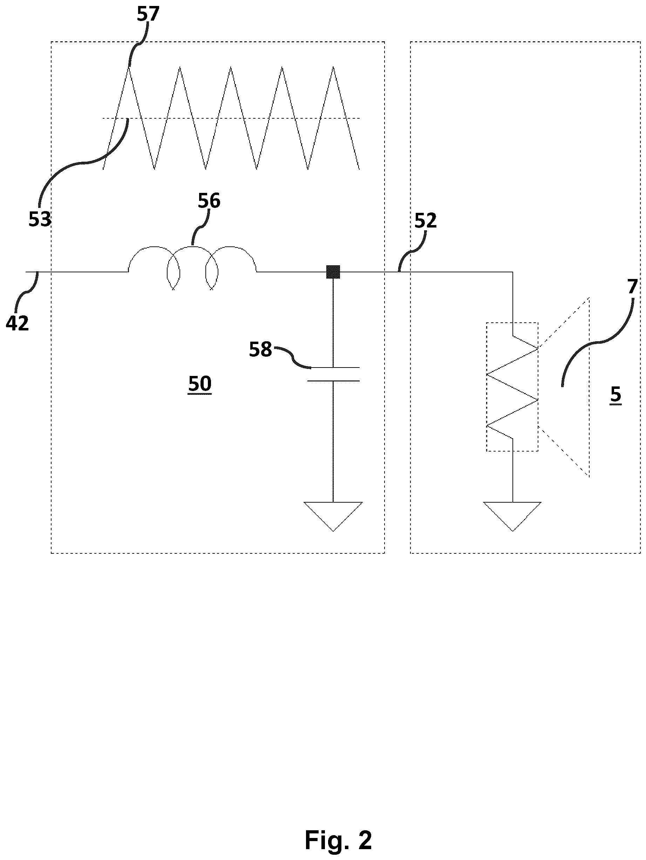

Figure 2 illustrates one embodiment of an output stage 50 connected to a load 5. The output stage 50 comprises an inductor 56 having an inductor ripple current (57, not shown here) and a capacitor 58 combining to provide a low-pass filter. The output stage 50 receives an amplified output signal 42 from a switching amplifier which is filtered by the low-pass filter to generate an output signal 52. The output signal 52 is transmitted to a load 5. The load 5 comprises a speaker driver 7 configured to produce sound when receiving the output signal 52, the speaker driver 7 has a resistance. In one aspect, the output stage 50 may be comprised in the switching amplifier, or it may be arranged external to the switching amplifier e.g., in a crossover processor or in a speaker enclosure.

As explained in fig. 1B, signals may be transmitted from the output stage 50 to a frequency controller in a switching amplifier, the signals may be a current of the inductor 56, a current of the capacitor 58 and/or the output signal 52. The signals are used to determine the output power transmitted to the load 5. The signals may be measured directly or indirectly, e.g. by using a shunt resistor or a hall-effect sensor.

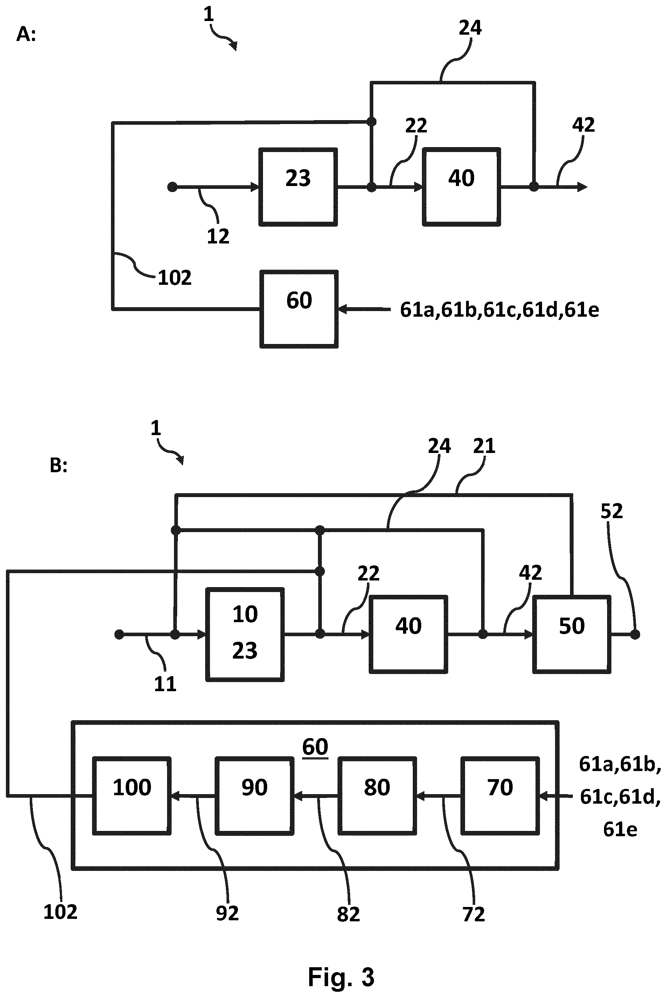

Figure 3A illustrates one embodiment of a switching amplifier 1 comprising a self-oscillating hysteresis modulator 23, a power stage 40 and a frequency controller 60. The frequency controller 60 receives a second control signal 61a,61b,61c,61d,61e similar to the embodiments in fig. 1A-1C. The power stage 40 is similar to the embodiments in fig. 1A-1C.

The self-oscillating hysteresis modulator 23 receives a second feedback signal 24 based on the amplified output signal 42. The frequency controller 60 is configured to generate a hysteresis control signal 102, wherein the hysteresis control signal 102 is a pulse signal having decreasing frequency for high amplified output signal 42 and increasing frequency for low amplified output signal 42. The hysteresis control signal 102 is actively clamped between the second feedback signal 24 and the pulse signal 22 generated by the self-oscillating hysteresis modulator 23.

The hysteresis control signal 102 and the second feedback signal 24 ensures that the switching frequency of the switching amplifier 1 is adjusted according to the output power of the switching amplifier 1 as derived from the second control signal 61a,61b,61c,61d,61e. Hence, the switching frequency is increased at an idle output power and decreased at higher output power.

Figure 3B illustrates one further embodiment of the switching amplifier 1 illustrated in fig. 3A. In this embodiment, the switching amplifier comprises an output stage 50, and an input stage 10 combined with the self-oscillating hysteresis modulator 23. The input stage 10 receives the first feedback signal 21 and the second feedback signal 24 combined with the input signal 11. The hysteresis control signal 102 is actively clamped between the second feedback signal 24 and the pulse signal 22, as described in fig. 3A.

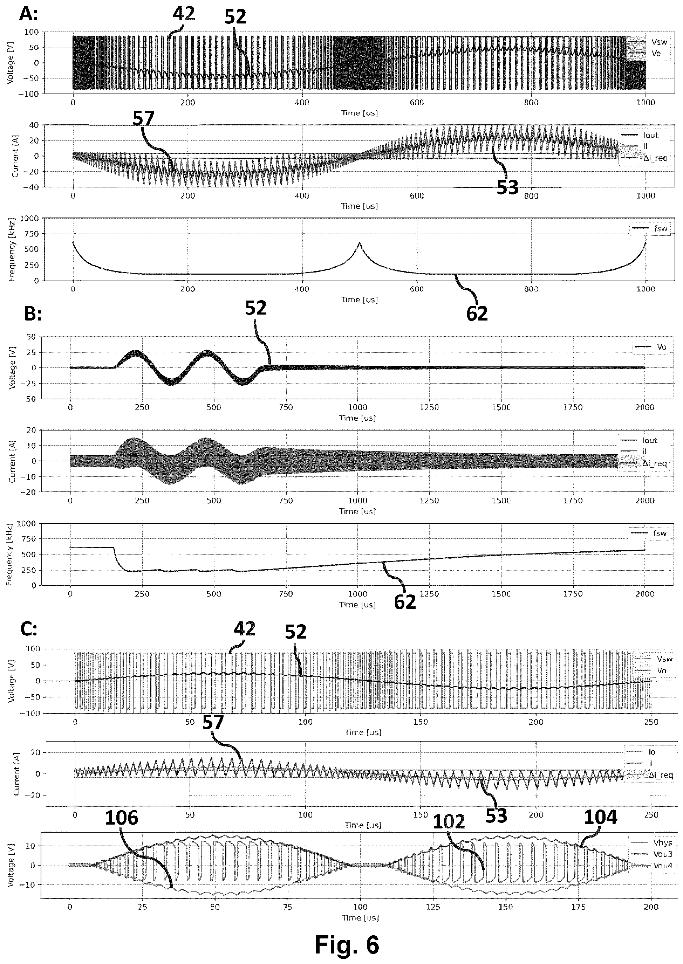

The frequency controller 60 comprises:
- a sensing circuit 70 configured for generating a sensed signal 72 based on the one or more second control signals 61a,61b,61c,61d,61e;
- a rectifier circuit 80 configured for generating a rectified signal 82 based on the sensed signal 72;
- a clamping inverter 90 configured for generating a clamped signal 92, wherein the clamped signal 92 is low for low magnitudes of the one or more second control signals 61a,61b,61c,61d,61e and the clamped signal 92 is high for high magnitudes of the one or more second control signals 61a,61b,61c,61d,61e; and
- a hysteresis clamp 100 configured for generating the hysteresis control signal 102 comprising a positive-shifted clamper signal 104 (see fig. 6C) and a negative-shifted clamper signal 106 (see fig. 6C) based on the clamped signal 92.

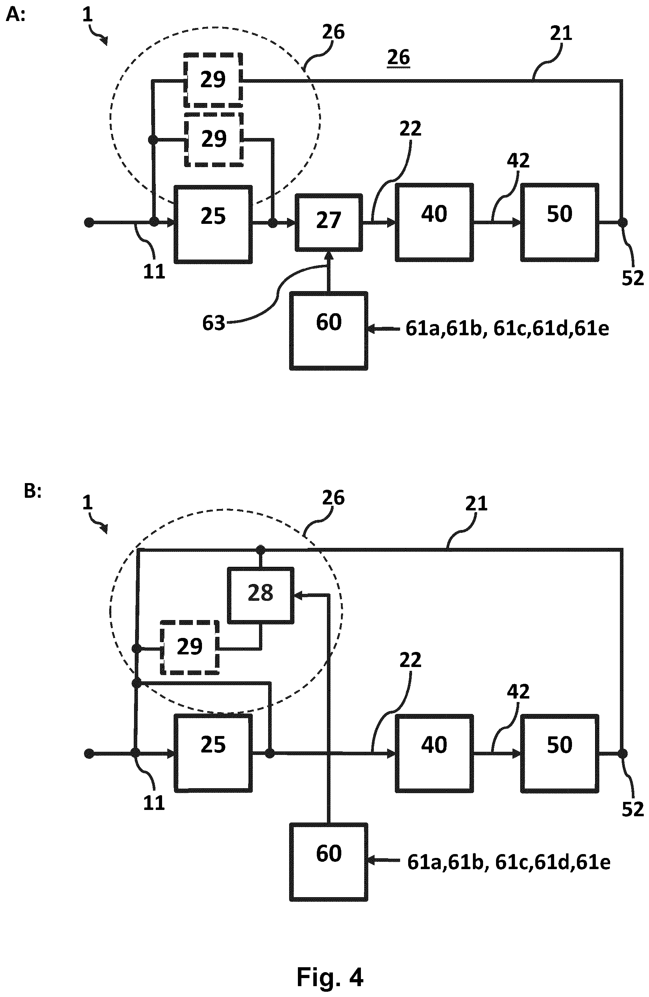

Figure 4A illustrates one embodiment of a switching amplifier 1 with a self-oscillating phase-shift modulator 25. The self-oscillating phase-shift modulator 25 comprises a control-loop 26 configured to generate oscillation having the switching frequency. The control-loop 26 may comprise a combination of gain-, pole- and zero-components 29 configured to generate the oscillation. The oscillation may be generated in combination with one or more active components, such as an operational amplifier. The operational amplifier may be the component receiving the first control signal 11. The control-loop also receives a first feedback signal 21, which may be received from an output stage 50 of the switching amplifier 1 and/or an output load. The control-loop 26 may be a feedback loop, a forward path, a feed-forward loop, an open-loop control and/or a combination thereof.

The output of the self-oscillating phase-shift modulator 25 is fed to a delay block 27 where a delay 63 is introduced by a frequency controller 60 to the output of the self-oscillating phase-shift modulator 25. The delay may be generated by passive resistor and/or capacitor components. From the delay block 27, a pulse signal 22 is fed to the power stage 40 or to a gate driver (30, shown in fig. 1C). By introducing the delay 63 to the output of the self-oscillating phase-shift modulator 25, the switching frequency of the output is adjusted by the frequency controller 60 according to the active frequency control. The AFC may be based on one or more second control signals 61a, 61b, 61c, 61d, 61e, as previously described in other embodiments of the switching amplifier 1.

Figure 4B illustrates one further embodiment of a switching amplifier 1 with a self-oscillating phase-shift modulator 25. Similar to the embodiment in fig. 4A, the self-oscillating phase-shift modulator 25 comprises a control-loop 26 and optionally a combination of gain-, pole- and zero-components 29 configured to generate the oscillation. The oscillation may be generated in combination with one or more active components.

In this embodiment, one or more components in the control-loop 26 are configured to generate a controllable delay 28 in the control-loop to adjust a time constant of the control-loop and thus adjust the switching frequency of the pulse signal 22. This may be provided by a controllable resistance, a controllable capacitor, a connection/disconnection of the capacitor in the control-loop 26 and/or a combination thereof. The controllable delay 28 is controlled by the frequency controller 60 in order to implement AFC. The AFC may be based on one or more second control signals 61a, 61b, 61c, 61d, 61e, as previously described in other embodiments of the switching amplifier 1.

Figure 5A illustrates time domain graphs of electrical signals of a switching amplifier connected to a 4 Ohm load. The switching amplifier is the embodiment illustrated in fig. 1B or 1C.

The first graph illustrates a voltage of the amplified output signal 42 generated by the power stage and the voltage of the output signal 52 generated by the output stage. The graph illustrates how the switching frequency 62 of the amplified output signal 42 is increased as the output signal is near idle (0 Voltage) and the switching frequency 62 is decreased as the output signal 42 is increased. I.e., the switching frequency 62 is increased in particular in the time range from 0 to 15 microseconds (us), 120 to 135 us and 235 to 250 us along the time scale (x-axis). The increase and decrease of the switching frequency 62 is illustrated in the third graph (the bottom graph).

The second graph illustrates the inductor ripple current 57 and the output current 53 of the switching amplifier. The inductor ripple current 57 arises from high frequency ripple currents due to the inductance of the inductor in the output stage. The graph also has two horizontal lines 59, the two lines indicate a minimum desired absolute value of the peak inductor ripple current 57 during switching events of the transistors of the power stage of the switching amplifier, the minimum desired absolute value is the minimum value required in order for the switching amplifier to achieve ZVS.

Figure 5B illustrates time domain graphs of electrical signals of a switching amplifier connected to three different loads, the switching amplifier is similar to the embodiment also used for the graphs in fig. 5A. The first graph illustrates the voltage of the output signal 52. The three tested loads are 4 Ohm, 10 Ohm, and 100 Ohm. The second graph illustrates the varying switching frequency 62 for each load as the voltage of the output signal 52 varies. The two graphs illustrate that the adjustment of the switching frequency 62 by the frequency controller of the switching amplifier is load dependent, as a larger load, e.g., the 10 Ohm and 100 Ohm loads have a higher switching frequency 62 across the entire period of time of the signal compared to the 4 Ohm load. It is only near zero voltage that the switching frequency 62 across all three loads are equal. See e.g., at 0 us, 125 us and 250 us time.

Figure 6A illustrates three time domain graphs of electrical signals of a switching amplifier, similar to fig. 5A, wherein the switching amplifier is configured with a minimum switching frequency 62 of approximately 100 kHz.

Figure 6B illustrates three time domain graphs of electrical signals of a switching amplifier, similar to fig. 5A and 6A, wherein the input signal and/or the first control signal is a signal having two sine wave periods with a high amplitude followed by no signal. In this illustration, the switching amplifier is configured to hold the switching frequency 62 substantially constant momentarily after a reduction in switching frequency 62 and before the switching frequency 62 is steadily increased to a higher switching frequency.

The first graph only illustrates the output signal 52 and the third graph illustrates how the switching frequency 62 of the switching amplifier is held substantially constant momentarily after a fast reduction in switching frequency 62 during the onset of the burst (at approximately 200 us).

Figure 6C illustrates three time domain graphs of electrical signals of a switching amplifier. The three graphs are similar to fig. 5A while the switching amplifier is the embodiment having a self-oscillating hysteresis modulator described in fig. 3A and 3B. The first graph illustrates the amplified output signal 42 and the output signal 52. The second graph illustrates how the switching amplifier with the self-oscillating hysteresis modulator is able to achieve ZVS or RVS by the inductor ripple current 57 being larger than the output current 53. The third graph illustrates the hysteresis control signal 102, the positive-shifted clamper signal 104, and the negative-shifted clamper signal 106. This graph illustrates that the shifting frequency is increased during idle and decreased at high output signal 52 due to the hysteresis clamping.

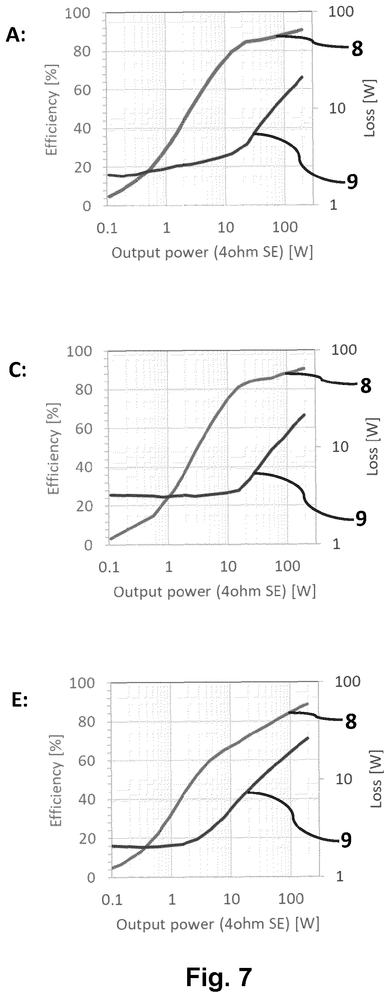

Figures 7A to 7C illustrates efficiency 8 (drawn in grey) and loss 9 (drawn in black) graphs of three switching amplifiers relative to the output power. In each graph, an efficiency scale is drawn on the left side, the loss scale measured in watts (W) is on the right side and on the bottom scale is the output power measured in watts. Each switching amplifier transmits the output signal to a 4 Ohm load.

Figure 7A illustrate the efficiency 8 and loss 9 of a switching amplifier according to the present invention with active frequency enabled. Fig. 7B illustrate the efficiency and loss of a switching amplifier according to the present invention with active frequency disabled. Fig. 7C illustrate the efficiency and loss of an unmodified switching amplifier. Common for the three switching amplifiers, is that the power supply has a +/- 85 V supply voltage; each switching amplifier has a single active channel; and the power stages use the same MOSFET. The switching amplifiers with AFC enabled and disabled (fig. 7A and 7B, respectively) have an output stage as illustrated in fig. 2A comprising a 2 uF capacitor and a 10 uH inductor, while the unmodified switching amplifier in fig. 7C has an output stage with a 1 uF capacitor and a 20 uH inductor.

The three graphs illustrate the measured efficiency and associated losses for the three switching amplifiers. The amplifiers with low output stage inductance achieves higher efficiency much faster than the unmodified switching amplifier. In fact, losses are reduced with 50% at 20 W output power compared to the unmodified switching amplifier, e.g. 4 W of losses instead of 8 W. However, though the efficiency for the AFC enabled switching amplifier looks very similar to the AFC disabled switching amplifier it is worth noting that power loss below 2 W output power is up to 1.5 W lower for the AFC enabled switching amplifier. That is 40% reduction of losses. This is due to the reduction of core losses in the output stage filter inductance.

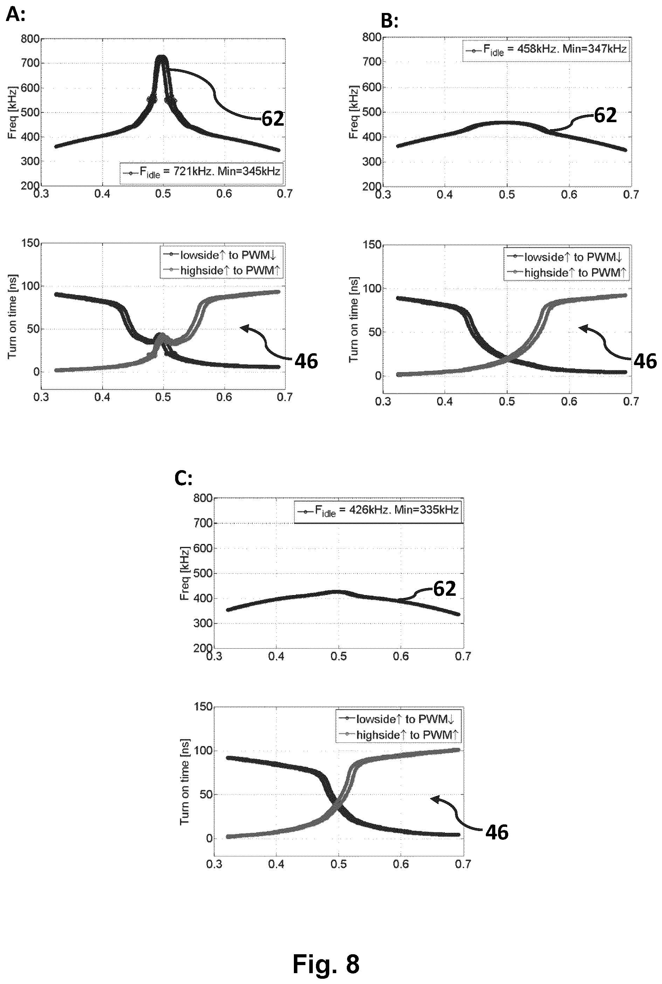

Figures 8A to 8C illustrate switching characteristics of three switching amplifiers. The switching amplifiers illustrated in fig. 8A, 8B, and 8C are the same switching amplifiers tested in fig. 7A, 7B and 7C, respectively. Common for each graph in the three figures is that the x-axis is the duty cycle. Furthermore, in the turn-on time graph (the second graph in each figure), the black curve is the high-side rising at high PWM signal, and the grey curve is the low-side rising at a low PWM signal, wherein the PWM signal is the pulse signal generated by a modulator in the switching amplifier.

Figures 8A to 8C illustrate the switching frequency 62 vs. duty cycle and the turn on-time 46 of the transistors in the power stage. At a lower turn-on time 46 the switching is the so-called soft switching, where a lower turn-on time 46 equals a softer switching. When the turn-on time 46 is approximately 75 ns the transistor is fully hard-switching and the linear increase of turn-on time 46 from this level and up is due to the increased current flowing in the body diode before turn-on which must be reversed. Comparing the three figures show that the AFC enabled switching amplifier increases the switching frequency 62 significantly around 0.5 duty cycle up to 721 kHz, without sacrificing the level of soft switching compared to the unmodified switching amplifier. Moreover, soft switching is extended for a much broader duty cycle range, i.e. from 0.48-0.52 to 0.43-0.57, which in turn translate into minimized switching losses.

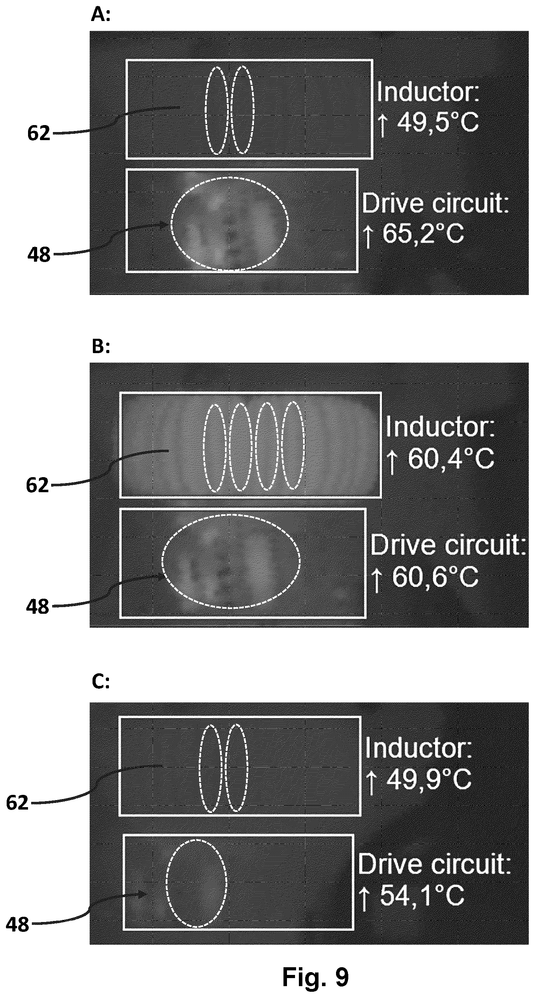

Figure 9A to 9C illustrate thermography images of circuit components of three switching amplifiers operating in steady state. The switching amplifiers illustrated in fig. 9A, 9B, and 9C are the same switching amplifiers tested in fig. 7A, 7B, and 7C, respectively.

The thermography images show that the minimized core losses translate into reduced inductor 56 idle temperature of the AFC enabled switching amplifier (fig. 9A) of >10 degrees Celsius compared to the AFC disabled switching amplifier (fig. 9B). This temperature is very similar to the temperature of the unmodified switching amplifier (fig. 9C). The drive circuit 48 of the AFC enabled switching amplifier is warmer due to higher gate losses from the increased switching frequency, but gate losses typically do not dominate the total idle loss, hence the AFC enabled switching amplifier is superior in terms of efficiency and losses as illustrated in fig. 7A to 7C.

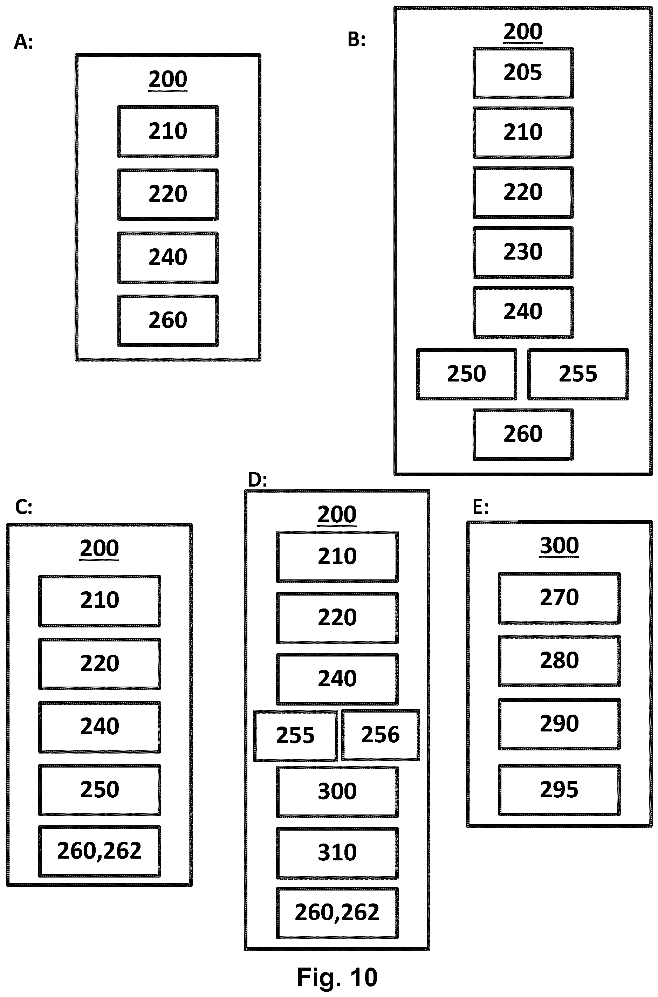

Fig. 10A illustrates one embodiment of a method 200 for adjusting a switching frequency of a switching amplifier in order to reduce combined amplifier switching losses and magnetic core losses, wherein the method comprises the steps of:
- receiving 210 a first control signal;
- generating 220 a pulse signal with the switching frequency, wherein the pulse signal is based on the first control signal;
- amplifying 240 the pulse signal to generate an amplified output signal having an output power; and
- adjusting 260 the switching frequency by increasing the switching frequency at low amplified output signal and by reducing the switching frequency at high amplified output signal.

Figure 10B illustrates an aspect, of the method 200 of fig. 10A which may comprise one or more further steps chosen among:
- generating 205 a first control signal based on an input signal; and/or
- generating 230 a gate current configured to drive transistors used to amplify the pulse signal, wherein the gate current is based on the pulse signal; and/or
- filtering 250 the amplified pulse signal so that an output signal is generated; and/or
- generating 255 a first feedback signal based on the amplified output signal.

Figure 10C illustrates a further embodiment of the method 200, the method comprises a further step of:
- filtering 250 the amplified pulse signal so that an output signal is generated, wherein the filtering is achieved by a capacitor and an inductor having an inductor ripple current.

In a further aspect of the method 200, the method may comprise a step of adjusting 262 the switching frequency so that a magnitude of the inductor ripple current of the inductor is larger than a current of the output signal and/or a signal determining the output signal.

Figure 10D illustrates a further embodiment of the method 200, the step of generating 220 the pulse signal comprises further steps of:
- generating 256 a second feedback signal based on the amplified output signal;
- generating 300 a hysteresis control signal based on the second control signal, wherein the hysteresis control signal is a pulse signal having decreasing frequency for high amplified output signal and increasing frequency for low amplified output signal; and
- clamping 310 the hysteresis control signal between the second feedback signal and the pulse signal.

In one aspect, the hysteresis control signal may be based on a signal determining an output signal of the switching amplifier, i.e., the signal transferred to a load.

Figure 10E illustrates a further aspect of the step of generating 300 the hysteresis control signal, wherein the step comprises further steps of:
- sensing 270 the output signal current to generate a sensed signal;
- rectifying 280 the sensed signal to generate a rectified signal;
- generating 290 a clamped signal based on the rectified signal, wherein the clamped signal is low for low magnitudes of the output signal current and the clamped signal is high for high magnitudes of the output signal current; and
- generating 295 the hysteresis control signal comprising a positive-shifted clamper signal and a negative-shifted clamper signal based on the clamped signal.

The method 200 according to any one or more embodiments and/or aspects may be used to control the switching amplifier as illustrated in any one of fig. 1A, 1B, 3A, 3B, 4A or 4B.

## Claims

1. A switching amplifier (1) for generating an amplified output signal (42), wherein the switching amplifier comprises:
- a modulator (20) configured for generating a pulse signal (22) with a switching frequency (62), wherein the pulse signal (22) is based on a first control signal (12);
- a power stage (40) comprising at least two transistors, wherein the power stage is configured for generating an amplified output signal (42) based on the pulse signal (22); and
- a frequency controller (60) configured for adjusting the switching frequency (62) of the modulator (20), wherein the switching frequency is increased at low amplified output signal (42) and the switching frequency is reduced at high amplified output signal.

2. The switching amplifier (1) according to claim 1, wherein the frequency controller (60) is configured for adjusting the switching frequency (62) based on one or more second control signals (61a,61b,61c,61d,61e) measured directly and/or indirectly, wherein the one or more second control signals are configured to determine an output current, wherein the one or more second control signals are chosen among:
- the first control signal (12); and/or
- a voltage of the amplified output signal (42); and/or
- a current of the amplified output signal (42); and/or
- a current draw of a power supply (45) powering the power stage (40); and/or
- a voltage of the power supply (45) powering the power stage (40).

3. The switching amplifier (1) according to claim 1 or 2, wherein the switching amplifier comprises an output stage (50) configured for generating an output signal (52), wherein the output stage comprises a capacitor (58) and an inductor (56) having an inductor ripple current (57).

4. The switching amplifier (1) according to claim 3, wherein the frequency controller (60) is configured for adjusting the switching frequency (62) based on one or more second control signals (61a,61b,61c,61d,61e) measured directly and/or indirectly, wherein the one or more second control signals are configured to determine an output current, wherein the one or more second control signals are chosen among:
- a voltage of the output signal (52); and/or
- a current of the output signal (52); and/or
- a current of the inductor (56); and/or
- a current of the capacitor (58).

5. The switching amplifier (1) according to any one of the preceding claims, wherein the frequency controller (60) is configured to hold the switching frequency (62) constant momentarily after a reduction in switching frequency and before the switching frequency is increased.

6. The switching amplifier (1) according to any one of claims 1 to 5, wherein the frequency controller (30) is an external carrier generator configured to generate a carrier waveform having the switching frequency (62) and configured to transmit the carrier waveform to the modulator (20), wherein the modulator (20) generates the pulse signal (22) based on the first control signal (12) and the carrier waveform.

7. The switching amplifier (1) according to any one of claims 2 to 5, wherein the modulator (20) is a self-oscillating hysteresis modulator (23) receiving:
- a second feedback signal (24) based on the amplified output signal (42); and/or
- a hysteresis control signal (102) generated by the frequency controller (60) and based on the one or more second control signal (61a,61b,61c,61d,61e), wherein the hysteresis control signal is a pulse signal having decreasing frequency for high amplified output signal (42) and increasing frequency for low amplified output signal,
wherein the hysteresis control signal (102) is actively clamped between the second feedback signal (24) and the pulse signal (22) generated by the self-oscillating hysteresis modulator (23).

8. The switching amplifier (1) according to any one of claims 1 to 5, wherein the modulator (20) is a self-oscillating phase-shift modulator (25) comprising a control-loop (26) configured to generate oscillation with the switching frequency (62) and wherein the frequency controller (60) is configured to adjust the switching frequency (62) of the oscillation by introducing a delay (63) to the control-loop (26).

9. The switching amplifier (1) according to any one of the preceding claims, wherein the transistors of the power stage (40) are chosen among bipolar junction transistors, field-effect transistors, junction field-effect transistors, metal-oxide-semiconductor field-effect transistors, gallium nitride field-effect transistors, silicon carbide field-effect transistors, and/or insulated-gate bipolar transistor.

10. An active speaker comprising one or more speaker drivers (7) and one or more switching amplifier (1) according to any one of claims 1 to 9, wherein the switching amplifier is configured for powering the one or more speaker drivers (7).

11. A method (200) for adjusting a switching frequency (62) of a switching amplifier (1) in order to reduce combined amplifier switching losses and magnetic core losses, wherein the method comprises the steps of:
- receiving (210) a first control signal (12);
- generating (220) a pulse signal (22) with a switching frequency (62), wherein the pulse signal (22) is based on the first control signal (12);
- amplifying (240) the pulse signal (22) to generate an amplified output signal (42) having an output power; and
- adjusting (260) the switching frequency (62) by increasing the switching frequency at low amplified output signal (42) and by reducing the switching frequency at high amplified output signal.

12. The method (200) according to claim 11, wherein in the step of adjusting (260) the switching frequency (62), the switching frequency is based on one or more second control signal (61a,61b,61c,61d,61e) measured directly and/or indirectly, wherein the one or more second control signals are configured to determine an output current, wherein the one or more control signals are chosen among:
- the first control signal (12); and/or
- a voltage of the amplified output signal (42); and/or
- a current of the amplified output signal (42); and/or
- a current draw of a power supply used in the step of amplifying (240) the pulse signal (22); and/or
- a voltage of the power supply used in the step of amplifying (240) the pulse signal (22).

13. The method (200) according to claim 11 or 12, wherein the method comprises a further step of:
- filtering (250) the amplified pulse signal (42) so that an output signal (52) is generated, wherein the filtering is achieved by a capacitor (58) and an inductor (56) having an inductor ripple current (57).

14. The method (200) according to claim 13, wherein the step of adjusting (260) the switching frequency (62), the switching frequency is based on one or more second control signals (61a,61b,61c,61d,61e) measured directly and/or indirectly, wherein the one or more second control signals are configured to determine an output current, wherein the one or more second control signals are chosen among:
- a voltage of the output signal (52); and/or
- a current of the output signal (52); and/or
- a current of the inductor (56); and/or
- a current of the capacitor (58).

15. The method (200) according to any one of claims 11 to 14, wherein the step of generating (220) the pulse signal comprises further steps of:
- generating (256) a second feedback signal (24) based on the amplified output signal (42);
- generating (300) a hysteresis control signal (102) based on the second control signal (61a,61b,61c,61d,61e), wherein the hysteresis control signal is a pulse signal having decreasing frequency for high amplified output signal (42) and increasing frequency for low amplified output signal; and
- clamping (310) the hysteresis control signal (102) between the second feedback signal (24) and the pulse signal (22).
